Europäisches Patentamt

European Patent Office

Office européen des brevets

(11) Publication number: **0 668 618 A2**

## EUROPEAN PATENT APPLICATION

(21) Application number: **94107763.8**

(22) Date of filing: **19.05.94**

(51) Int. Cl.⁶: **H01L 29/88**, H01L 29/73, H01L 21/329, H01L 21/331

(30) Priority: **20.05.93 US 65087**

(43) Date of publication of application:
**23.08.95 Bulletin 95/34**

(84) Designated Contracting States:
**DE FR GB IT NL**

(71) Applicant: **TEXAS INSTRUMENTS INCORPORATED**
**13500 North Central Expressway**
**Dallas**
**Texas 75265 (US)**

(72) Inventor: **Bate, Robert T.**
**3106 Kristin Court**
**Garland, TX 75044 (US)**
Inventor: **Cho, Chih-Chen**
**2010 North Cliff**
**Richardson, TX 75082 (US)**
Inventor: **Gnade, Bruce E.**
**12219 Cross Creek**
**Dallas, Texas 75243 (US)**
Inventor: **Reed, Mark**
**330 Willow Street**
**New Haven, CT 06511 (US)**

(74) Representative: **Schwepfinger, Karl-Heinz, Dipl.-Ing. et al**
**Prinz & Partner,**
**Manzingerweg 7**
**D-81241 München (DE)**

(54) **Resonant tunneling devices.**

(57) A resonant tunneling device and method of making same wherein the tunneling device includes a quantum well composed of silicon, and a pair of tunneling barriers of a material having a bandgap wider than that of silicon and epitaxially depositable on silicon on opposing surfaces of the quantum well. Aluminium can be substituted for the silicon. The tunneling barriers can be doped with a p-type or n-type dopant. A contact is disposed on each of the barrier layers and remote from the quantum well. In a further embodiment, there are provided second and third layers of silicon, each disposed on one of the tunneling barriers and remote from the quantum well, the contacts being connected to the second and third layers of silicon. In a further embodiment, a third contact is disposed on the quantum well.

## FIG. 5B

EP 0 668 618 A2

## BACKGROUND OF THE INVENTION

### FIELD OF THE INVENTION

This invention relates to Si/CaF$_2$, Al/CaF$_2$ and Al/Si/Al/Si resonant tunneling devices.

### BRIEF DESCRIPTION OF THE PRIOR ART

The background of the invention is described herein by way of example in connection with quantum well devices in which resonant tunneling through the well is modulated. However, it should be understood that the invention herein is not so limited and relates to resonant tunneling devices in general.

Heretofore, in the field of resonant tunneling devices, quantum well devices have been known in various forms, heterostructure lasers being a good example. Quantum well heterostructure lasers rely upon the discrete energy levels in the quantum wells to achieve high efficiency and typically consist of a few coupled quantum wells as generally discussed in Sze, Physics of Semiconductor Devices, pages 729-30 (Wiley Interscience, 2d Ed., 1981). High electron mobility transistors (HEMTs) are another type of quantum well device and typically use only one half of a quantum well (a single heterojunction), but may include a stack of several quantum wells. The HEMT properties arise from conduction parallel to the heterojunctions and in the quantum well conduction or valence subbands. The conduction carriers (electrons or holes) are isolated from their donors and this isolation limits impurity scattering of the carriers. Superlattices consist of many quantum wells which are so tightly coupled that the individual wells are indistinguishable and become analogous to atoms in a lattice. Consequently, superlattices behave more like new types of materials than as groups of coupled quantum wells.

Resonant tunneling devices are the simplest quantum well devices that exhibit quantum confinement and coupling and were first investigated by L. Chang et al., 24 Applied Physics Letters 593 (1974), who observed weak structure in the current-voltage characteristics of resonant tunneling diodes at low temperatures.

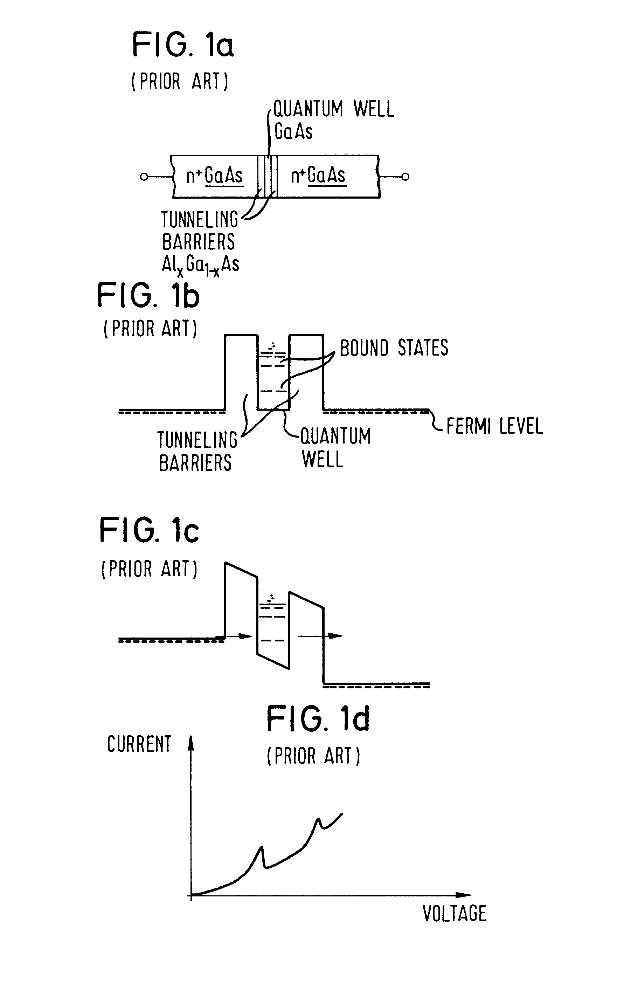

A typical prior art resonant tunneling diode structure is shown schematically in FIGURES 1a-d wherein FIGURE 1a is a schematic cross sectional view, FIGURE 1b illustrates the profile of the conduction band edge through such a diode with no bias, *FIGURE 1c is the conduction band edge for bias into resonance and FIGURE 1d is a typical current-voltage characteristic for the diode at low temperature. The preferred material of the prior art devices is the lattice matched system of GaAs/Al$_x$Ga$_{1-x}$As. The two Al$_x$Ga$_{1-x}$As layers that define the central GaAs quantum well therebetween (see FIGURES 1b-c) serve as partially transparent barriers to electron transport through the diode. Resonant tunneling occurs when the bias across the outer terminals is such that only one of the quantum well bound states has approximately the same energy level as the input electrode Fermi level. This is illustrated by the arrows in FIGURE 1c. Peaks in electron transmission (current) as a function of bias (voltage) are thus observed (FIGURE 1d). The resonant tunneling diode is the electrical analog of a Fabry-Perot resonator. Leakage (inelastic tunneling current) is determined by the quality of the GaAs/Al$_x$Ga$_{1-x}$As interfaces and electron-phonon scattering.

It has long been desired to build a resonant tunneling device using silicon in order to capitalize on the extensive experience in silicon processing that has been developed by the semiconductor industry over the last several decades. Those desires have gone unfilled up to the present. Resonant tunneling has been demonstrated using a CaF$_2$/CoSi$_2$ triple barrier structure by Asada et al. The data were presented at the 1992 Device Research Conference. Asada's work is described in IETCE Transactions, E74, 3326 (1991) by Sakaguchi, Watanabe and Asada, "Proposal and Analysis of Quantum-Interference High-Speed Electron Devices Using Metal-Insulation Heterostructure" and Watanabe et al., "Epitaxial Growth and Electrical Conductance of Metal (CoSi$_2$)/Insulator Si(111)", J. Electronic Mat., 21, 783 (1982). Recent unpublished data by Asada has demonstrated room-temperature negative differential resistance for a CaF$_2$/CoSi$_2$ triple barrier structure. This work demonstrates that resonant tunneling devices can be fabricated using the CaF$_2$ metal system.

## SUMMARY OF THE INVENTION

Although resonant tunneling devices have been realized in GaAs/Al$_x$Ga$_{1-x}$As for several years, the development of these devices based in silicon has not occurred in the prior art. Resonant tunneling devices in a silicon based material have the advantage that they can utilize all of the process technology already developed for the silicon integrated circuit industry, especially the use of silicon dioxide as an insulator. The basic requirements for a resonant tunneling device based in silicon are that a material with a bandgap wider than silicon has to be capable of being epitaxially deposited on silicon and it must be possible to epitaxially deposit silicon on that material. The preferred embodiment of the present invention described hereinbelow comprehends such a resonant tunneling structure based upon a CaF$_2$/Si interface which meets the above

requirements. An Al/CaF$_2$ or Al/Si interface are also contemplated in accordance with the present invention. In this regard, reference is made to the articles "Electrical properties of low-temperature-grown CaF$_2$ on Si(111)" by C.C. Cho et al., Applied Physics Letters 60 (3), 20 January 1992, pp 338-340 ; "Epitaxial relations and electrical properties of low-temperature-grown CaF$_2$ on Si(111)" by C.C. Cho et al., Journal of Vacuum Science Technology A 10(4), July/August 1992, pp 769-774 and "Low Temperature Epitaxial Growth of Al on Si(111) and CaF$_2$ (111) Using Molecular Beam Epitaxy", by C. C. Cho and H. Y. Liu, Mat. Res. Soc. Symp. Proc., 221, 07 (1991), the contents of these articles being incorporated herein by reference.

For explanation of methods of metal-insulator metal semiconductor structures, reference should be made to European Patent Application 93102551.4 published under number 0557890, particularly Figures 2-4 and the associated description. Methods for improving the interface characteristic of CaF2 on silicon are disclosed in Application 93102540.7, published under number 0562273.

## BRIEF DESCRIPTION OF THE DRAWINGS

FIGURE 1a schematically illustrates a prior art resonant tunneling diode;

FIGURE 1b illustrates the profile of the conduction band edge through the diode of FIGURE 1a with no bias;

FIGURE 1c illustrates the profile of the conduction band edge for bias of the diode of FIGURE 1a into resonance;

FIGURE 1d is a typical current-voltage characteristic for the diode of FIGURE 1a at low temperature;

FIGURE 2 demonstrates that tunneling probability is proportional to the product of the height and width of the tunnel barrier;

FIGURES 3A and 3B are lattice diagrams showing two possible bonding schemes between Si and CaF$_2$;

FIGURE 4 is an energy band diagram of a CaF$_2$/Si heterojunction;

FIGURES 5A and 5B are cross sectional views of a first preferred embodiment of the present invention during different stages of fabrication;

FIGURE 6 is a plot of the low temperature I-V characteristics of the first preferred embodiment device of FIGURE 5;

FIGURES 7A and 7B are cross sectional views of a second preferred embodiment of the present invention during different stages of fabrication; and

FIGURE 7C is a cross sectional view of a third preferred embodiment of the present invention.

## DESCRIPTION OF THE PREFERRED EMBODIMENT

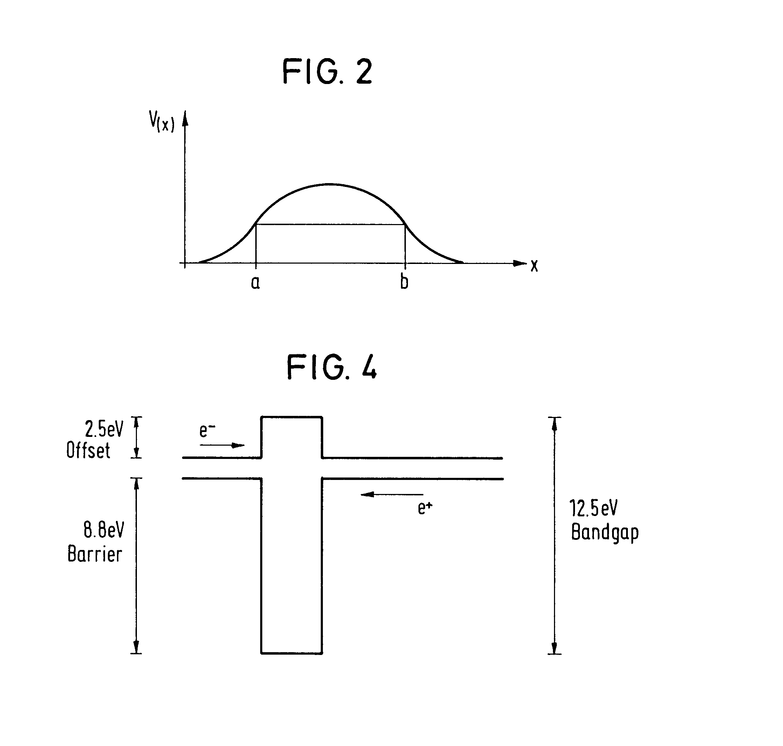

Previously, work on the deposition of CaF$_2$ on silicon has been dedicated to the development of a silicon-on-insulator technology. Because CaF$_2$ has a very similar lattice constant to silicon at room temperature (differing by only 0.3%), as well as the same crystal structure (diamond cubic), it can be deposited epitaxially on silicon. This satisfies one of the requirements for a resonant tunneling device based in silicon. Additionally, CaF$_2$ also meets the other criteria of being a wide bandgap material and having a bandgap wider than that of silicon. The energy bandgap of CaF$_2$ is approximately 12.5 eV whereas the bandgap of silicon is approximately 1.2 eV. Accordingly, layer structures for the CaF$_2$ of only a few angstroms, generally about 10 to 100 angstroms, are required because the tunneling current through a barrier is controlled by the height (in energy bandgap) and the width (see FIGURE 2) (thickness in physical dimensions) of the barrier. For any given barrier width, the higher the barrier bandgap, the lower the probability that tunneling will occur. Therefore, with a barrier height of 12.5 eV, the tunneling probability is extremely low. Assuming a square barrier with a width bounded by the points a and b in FIGURE 2, the relationship for tunneling probability versus height and width is given by the tunneling probability, T, where:

$$T = 4/(2\Theta + (1/2\Theta))^2$$

where $\Theta$ is a measure of the height (bandgap) and width (thickness) of the barrier as a function of energy and is given by:

$$\Theta = {}_a{\Large\ast}^{bv} (x)dx$$

Therefore, if the bandgap were equally divided between the conduction band and the valence band, the barrier height would be 6.25 eV or unacceptably large for a practical resonant tunneling device. A resonant tunneling device constructed from Si/CaF$_2$ would require layer structures of only a few angstroms to permit a reasonable tunneling current since the energy bandgap of CaF$_2$ is approximately 12.5 eV.

The band offset between the conduction band of silicon and that of CaF$_2$ is roughly 2.5 eV. This 2.5 eV offset makes a Si/CaF$_2$ resonant tunneling device possible because the barrier height in the conduction band is small enough to allow an appreciable tunneling current for barriers of 10-100 angstroms. Due to practical fabrication considerations, resonant tunneling devices are practical only if the barriers can be greater than 10 angstroms thick.

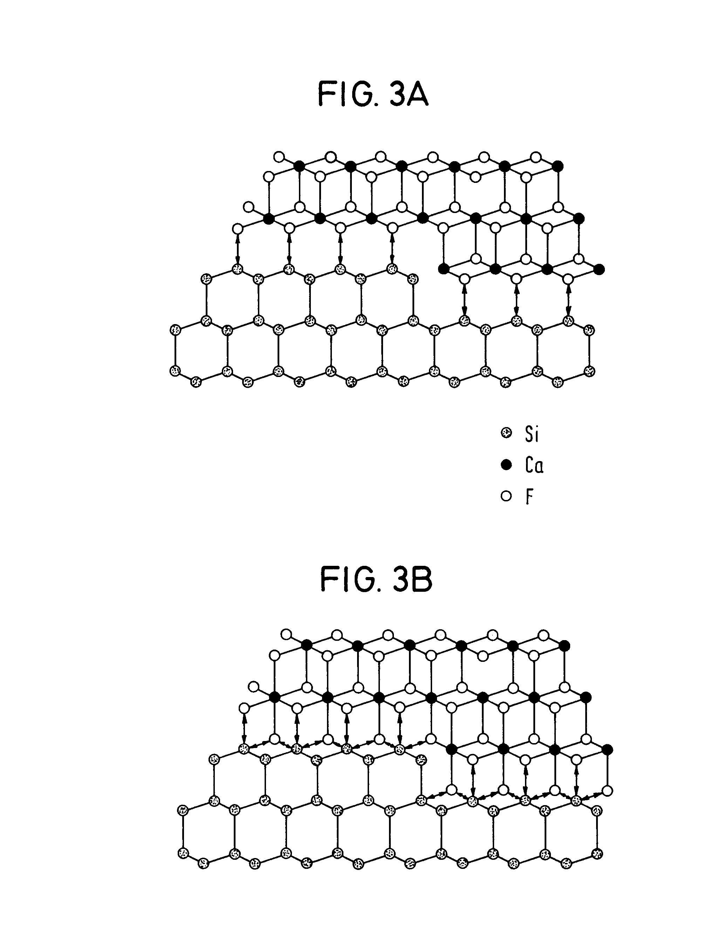

A very important feature of the Si/CaF$_2$ interface is that CaF$_2$ appears to bond to silicon in such a way as to passivate interface states. There are two explanations as to why this occurs which are generally accepted and which are in disagreement. The first argument is that at high temperature the CaF$_2$ dissociates when it first strikes the silicon surface, probably losing a fluorine atom to the environment. The other argument is that the CaF$_2$ does not dissociate and that the interface bonding is Ca-F-Si. As shown in FIGURE 3, when the CaF$_2$ is deposited on the silicon as A-type CaF$_2$, there is a layer of fluorine which is available to interact with the silicon "dangling" bond. This reduces the reactivity at the interface, which should lead to reduced interface charge traps and increased interface stability. The bonding is probably as shown in FIGURE 3A or FIGURE 3B with FIGURE 3B being more likely wherein solid black dots correspond to calcium, solid white dots correspond to fluorine and stippled dots correspond to silicon. The growth of A-type CaF$_2$ was first presented in U.S. Serial No. 07/704,535 which is assigned to the same assignee as the subject application, said application being incorporated herein by reference.

It is important to passivate the interface traps because the number of electrons passing through the well is small, therefore, if there are many traps at the interface, all of the electrons will be tied up. This is usually demonstrated by a flat C-V curve. If the number of interface traps is high, the performance of the device will be completely dominated by the interface traps.

Additionally, CaF$_2$ offers the advantage that the film can be thermally cycled, allowing for oxide processing. Even though there is a marked difference in the coefficients of thermal expansion between CaF$_2$ (19 x $10^{-6}$/$^\circ$K) and silicon (3 x $10^{-6}$/$^\circ$K), for the thin films required for resonant tunneling devices (<100 Angstroms) the layers can be strained during the thermal processing without causing mechanical damage (cracks and delaminations).

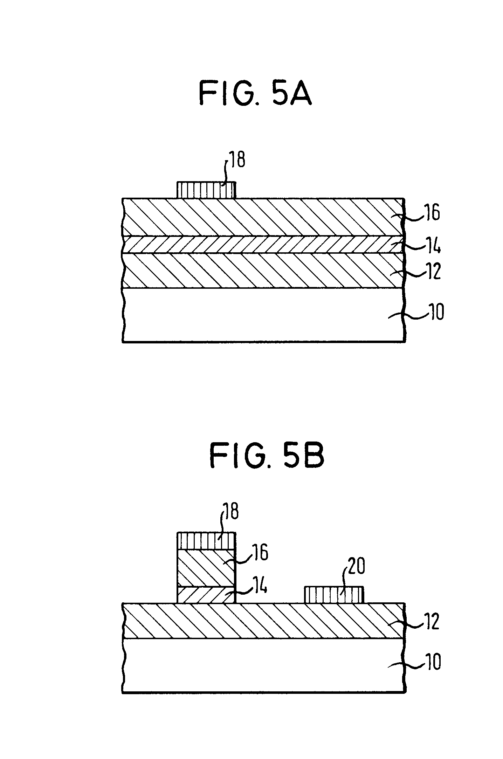

The fact that the conduction band offset between silicon and CaF$_2$ is 2.5 eV and the bandgap of CaF$_2$ is 12.5 eV is also advantageous. The 2.5 eV band offset is in the conduction band (the up direction in FIGURE 4). Since the bandgap of silicon is 1.2 eV, this leaves 8.8 eV for the barrier in the valence band (the total bandgap of CaF$_2$ is 12.5 ev). In the present case, if electron transport is in the conduction band, the barrier height with respect to electrons is 2.5 eV, while hole conduction, which occurs in the opposite direction, is in the valence band (the down direction in FIGURE 4) where the barrier height is 8.8 eV. This relates to the fact that the tunneling probability is proportional to the barrier height, as discussed above.

Also, a barrier this high permits the valley current to be reduced to a very low value, this being necessary for the device to switch efficiently. Valley current is analogous to leakage current or current being passed when the device is not in resonance. Having a low valley current or a large peak-to-valley ratio is important for two reasons. First, the larger the peak-to-valley ratio, the easier it is to sense when the device (for example, a resonant tunneling diode) is on. This is especially important for room temperature devices. Secondly, if the valley current is small, the device does not require much current when it is in the off state. This is especially important in quantum sized devices because the device density is so high that power consumption will be a problem unless the off state currents are extremely small. This will also affect the heat dissipation required. The large barrier height should also prevent the leakage from increasing at high temperatures (about 80$^\circ$C), the probable major failure mechanism of conventional MOSFETs with very small gate lengths.

A first preferred embodiment of the present invention is shown in FIGURES 5A-B. Horizontal and vertical dimensions are distorted for purposes of illustration. The structure is a single barrier resonant tunneling device. The single barrier structure is for the purpose of demonstrating that CaF$_2$ can be used as a barrier on silicon. As shown in FIGURE 5A, a layer 12 of silicon is epitaxially deposited on silicon substrate 10 to a thickness of 100 nanometers (1000 angstroms). Silicon layer 12 is doped to be n+ with antimony at a concentration of about 1 x $10^{18}$, for example. Next, a layer 14 of CaF$_2$ is epitaxially deposited on layer 12 to a thickness of 1 to 3 nanometers (10 to 30 angstroms). Then a layer 16 of silicon is epitaxially deposited on CaF$_2$ layer 14 to a thickness of 100 nanometers (1000 angstroms). Silicon layer 16 is doped to be n+ with antimony at a concentration of 1 x $10^{18}$, for example. A layer of photoresist (not shown) is then spun on the silicon layer 16 and patterned to define a device area. A layer of aluminium, for example, is deposited on the wafer. When the photoresist is stripped, aluminum contact 18 remains. Contact 18 is then used as a mask to isotropically etch all areas of the wafer not protected by the contact 18 down to silicon layer 12 using CF$_4$/O$_2$ as the etchant, for example. As shown in FIGURE 5B, another photoresist mask is then spun onto the exposed surface and patterned to define a second device contact. Another layer of aluminium, for example, is deposited on the wafer and then the photoresist is stripped, leaving second device contact 20. The exposed non-contact surfaces can optionally now be protected with a standard side wall oxide, spun on glass, or the like or additional CaF$_2$ (overgrowth).

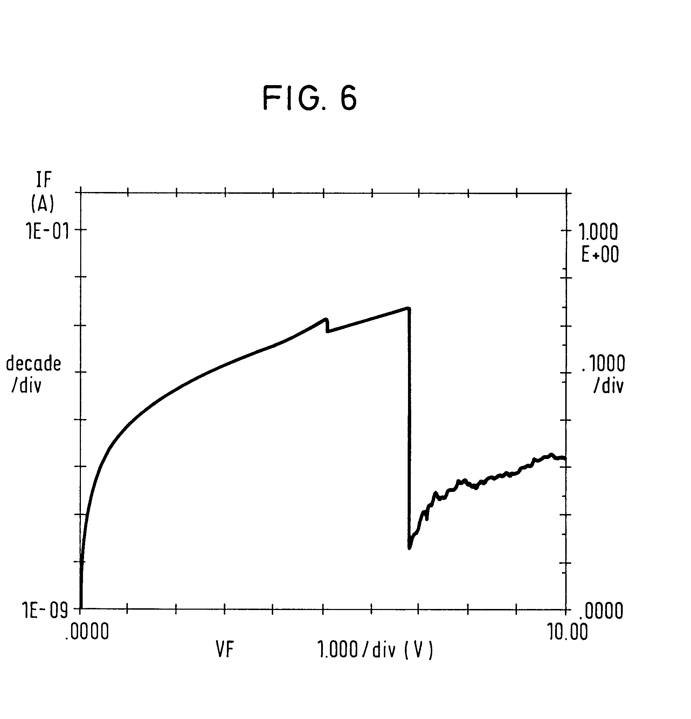

FIGURE 6 is a plot of the I-V characteristics of the first preferred embodiment device measured at 77°K. The linear region from approximately 2 to 5 volts indicates that the barrier is behaving like a tunneling barrier as compared to a dielectric film responding like a simple resistor (which would be a logarithmic response).

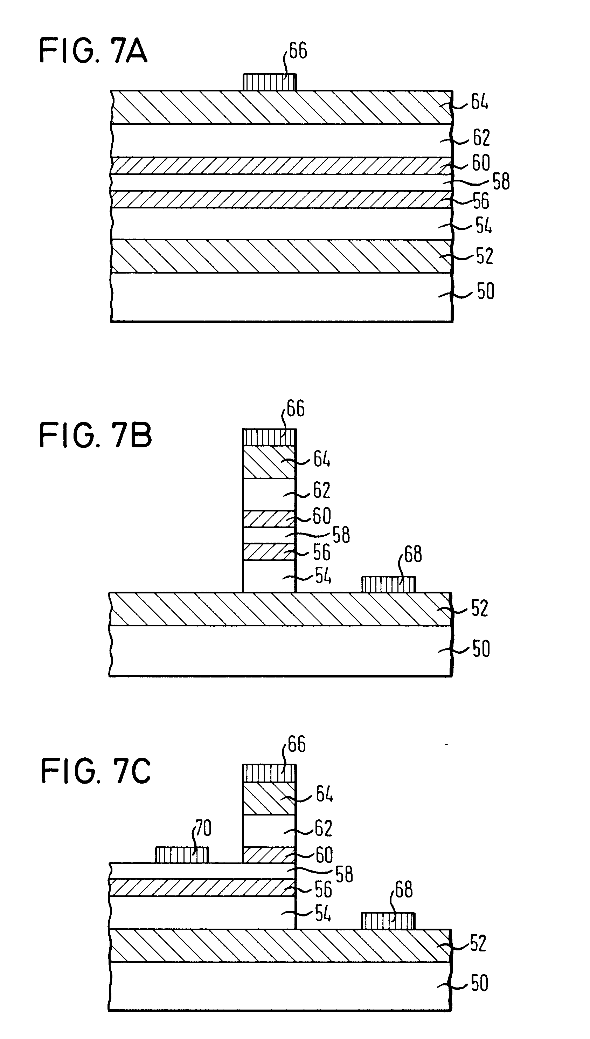

Second and third preferred embodiments of the present invention are shown in FIGURES 7A-C. Horizontal and vertical dimensions are distorted for purposes of illustration. The device is a double barrier resonant tunneling device. As shown in FIGURE 7A, which applies to both the second and third preferred embodiments, a silicon substrate 50 is provided and can be doped to be n++ with antimony to a concentration of $1 \times 10^{19}$, for example. The substrate does not have to be doped. Next, a 1 micron layer 52 of silicon is epitaxially deposited on substrate 50. Layer 52 is doped to be n++ with antimony to a concentration of $1 \times 10^{19}$, for example. A 100 angstrom layer 54 of undoped silicon is then epitaxially deposited on layer 52, onto which a 50 angstrom layer 56 of $CaF_2$ is deposited, followed by a 50 angstrom layer 58 of undoped silicon and then another 50 angstrom layer 60 of $CaF_2$. Next, a 100 angstrom layer 62 of undoped silicon is epitaxially deposited onto layer 60, followed finally by a 0.5 micron layer 64 of silicon doped to be n++ with antimony to a concentration of $2 \times 10^{19}$, for example. A layer of photoresist (not shown) is then spun onto the silicon layer 64 and patterned to define a device area. A layer of aluminium, for example, is deposited on the wafer. When the photoresist is stripped, aluminum contact 66 remains.

As shown in FIGURE 7B, the second preferred embodiment of the present invention is a two-terminal, double barrier device which may be formed when contact 66 is used as a mask to isotropically etch all areas of the wafer not protected by the contact 66 down to silicon layer 52 using $CF_4/O_2$ etchant, for example. Another photoresist mask (not shown) is spun onto the exposed surface and patterned to define a second device contact. Another layer of aluminium, for example, is deposited on the wafer and then the photoresist is stripped, leaving second device contact 68. It can be seen that a two terminal device has been provided.

As shown in FIGURE 7C, the third preferred embodiment of the present invention is a three-terminal, double barrier device which may be formed starting with the structure of FIGURE 7A. Contact 66 is used as a mask and all areas of the wafer not protected by the contact 66 are isotropically etched down to silicon layer 58 using $CF_4/O_2$ etchant, for example. Another photoresist mask (not shown) is spun onto the exposed surface and patterned to protect the area to the left of contact 66 in FIGURE 7C and the exposed areas of the wafer to the right of contact 66 are isotropically etched down to silicon layer 52 using $CF_4O_2$ etchant, for example. This photoresist mask is then stripped and a second photoresist mask (not shown) is spun onto the exposed surface and patterned to protect the area to the right of contact 66 in FIGURE 7C and the exposed areas of the wafer to the left of contact 66 are isotropically etched down to silicon layer 58 using $CF_4O_2$ etchant, for example. This second photoresist mask is stripped and removed and a third photoresist mask is spun onto the exposed surface and patterned to define contact regions 68 and 70. Another layer of aluminum, for example, is deposited on the wafer and then the photoresist is stripped, leaving contacts 68 and 70. It can be seen that a three terminal device has been provided.

A few preferred embodiments have been described in detail hereinabove. It is to be understood that the scope of the invention also comprehends embodiments different from those described, yet within the scope of the claims.

Internal and external connections can be ohmic, capacitive, direct or indirect via intervening circuits or otherwise. Implementation is contemplated in discrete components or fully integrated circuits.

Though the invention has been described with respect to specific preferred embodiments thereof, many variations and modifications will immediately become apparent to those skilled in the art. It is therefore the intention that the appended claims be interpreted as broadly as possible in view of the prior art to include all such variations and modifications.

## Claims

1. A method of making a resonant tunneling device comprising the steps of:

   (a) forming a quantum well composed of an element taken from the class consisting of silicon and aluminum; and

   (b) forming a pair of tunneling barriers of a material having a bandgap wider than that of said element and epitaxially depositable on said element on opposing surfaces of said quantum well.

2. The method of claim 1, wherein said material is calcium fluoride.

3. The method of claim 1 or claim 2 and further including the step of forming a contact disposed on each of said barrier layers and remote from said quantum well.

4. A resonant tunneling device comprising:
   (a) a quantum well composed of silicon or aluminium; and
   (b) a pair of tunneling barriers of a material epitaxially depositable on opposing surfaces of said quantum well.

5. The device of claim 4, wherein said material is calcium fluoride.

6. A resonant tunneling device as claimed in claim 4 or claim 5, wherein said a quantum well is composed of aluminium and said pair of tunneling barriers comprise one of a semiconductor material and one of an insulator.

7. The device of any of claims 4, 5 or 6, wherein said tunneling barriers are doped with a p-type dopant.

8. The device of any of claim 4 to 7, wherein said tunneling barriers are doped with an n-type dopant.

9. The device of any of claims 4 to 8, further including a contact disposed one of said barrier layers and remote from said quantum well.

10. The device of claim 9 further including a layer of silicon, said layer being disposed on one of said tunneling barriers and remote from said quantum well, said contact being connected to said layer of silicon.

11. The device of claim 10 and further including a further contact disposed on said quantum well.

# FIG. 1a
(PRIOR ART)

QUANTUM WELL
GaAs

n⁺GaAs    n⁺GaAs

TUNNELING
BARRIERS
$Al_x Ga_{1-x} As$

# FIG. 1b
(PRIOR ART)

BOUND STATES

FERMI LEVEL

TUNNELING
BARRIERS

QUANTUM
WELL

# FIG. 1c
(PRIOR ART)

# FIG. 1d
(PRIOR ART)

CURRENT

VOLTAGE

# FIG. 2

# FIG. 4

# FIG. 3A

⊕ Si
● Ca
○ F

# FIG. 3B

# FIG. 5A

18

16

14

12

10

# FIG. 5B

18

16

20

14

12

10

# FIG. 6

FIG. 7A

66

64
62
60
58
56
54
52
50

FIG. 7B

66

64
62
60
58
56
54

68

52
50

FIG. 7C

66

64
62
60
58
56
54

70

68

52
50